(19) Europäisches Patentamt
European Patent Office
Office européen des brevets

(11) **EP 1 269 627 B1**

(12) **EUROPÄISCHE PATENTSCHRIFT**

(45) Veröffentlichungstag und Bekanntmachung des Hinweises auf die Patenterteilung:
**15.08.2012 Patentblatt 2012/33**

(21) Anmeldenummer: **01915022.6**

(22) Anmeldetag: **20.02.2001**

(51) Int Cl.:
*H03H 9/00* *(2006.01)*    *H03H 9/145* *(2006.01)*

(86) Internationale Anmeldenummer:
**PCT/DE2001/000653**

(87) Internationale Veröffentlichungsnummer:
**WO 2001/071911 (27.09.2001 Gazette 2001/39)**

(54) **DUALMODE-OBERFLÄCHENWELLENFILTER MIT VERBESSERTER SYMMETRIE UND ERHÖHTER SPERRDÄMPFUNG**

DUAL-MODE SURFACE WAVE FILTER WITH IMPROVED SYMMETRY AND INCREASED REVERSE ATTENUATION

FILTRE A ONDES DE SURFACE BIMODE A SYMETRIE ET ATTENUATION INVERSE AMELIOREES

(84) Benannte Vertragsstaaten:
**CH DE FR GB LI**

(30) Priorität: **21.03.2000 DE 10013861**

(43) Veröffentlichungstag der Anmeldung:
**02.01.2003 Patentblatt 2003/01**

(73) Patentinhaber: **EPCOS AG**
**81669 München (DE)**

(72) Erfinder:
• **HAGN, Peter**
  **85464 Finsing (DE)**

• **SELMEIER, Peter**
  **83558 Maitenbeth (DE)**

(74) Vertreter: **Epping - Hermann - Fischer Patentanwaltsgesellschaft mbH Ridlerstrasse 55 80339 München (DE)**

(56) Entgegenhaltungen:
**WO-A-97/00556    DE-A- 19 818 826**

**Beschreibung**

Die vorliegende Erfindung bezieht sich auf ein vorzugsweise höchst selektives Hochfrequenz-Oberflächenwellenfilter vom Typ Dualmode-Oberflächenwellenfilter (DMS-OFW-Filter oder auch DMS-Filter). Es ist dafür auch die Bezeichnung Longitudinal modenresonatorfilter in Gebrauch. Diese DMS-Filter werden als Bandpaßfilter, vorzugsweise in schnurlosen oder zellularen Telefonen, eingesetzt. Nimmt man als Beispiel ein zellulares Telefon, so können die DMS-Filter im HF-Empfänger- oder Sendeteil sitzen. Im Empfängerteil werden DMS-Filter z.B. zwischen dem ersten rauscharmen Vorverstärker (LNA) und dem anschließenden Mischer positioniert, so daß nur das gefilterte Signal auf die Zwischenfrequenz umgesetzt wird.

Bekannt sind DMS-Filter z.B. als Einspur-Filter. Für eine höhere Selektion werden auch Filter hergestellt und verwendet, in denen zwei solcher Filterspuren zu einem Filter zusammengefasst kaskadiert auf einem Substrat angeordnet sind. Solche DMS-Filter sind z.B. aus der EP-0836278A bekannt. Die Figur 13 zeigt eine bekanntes kaskadiertes Zweispurfilter aus zwei miteinander verschalteten Einspur-DMS-Filtern.

Diese Ausführungsformen haben, bezogen auf die jeweilige Oberflächenwellenspur, jeweils endständige Resonator/Reflektorstrukturen und zwischen diesen für Signaleingang und für Signalausgang jeweils wenigsten einen Interdigitalwandler.

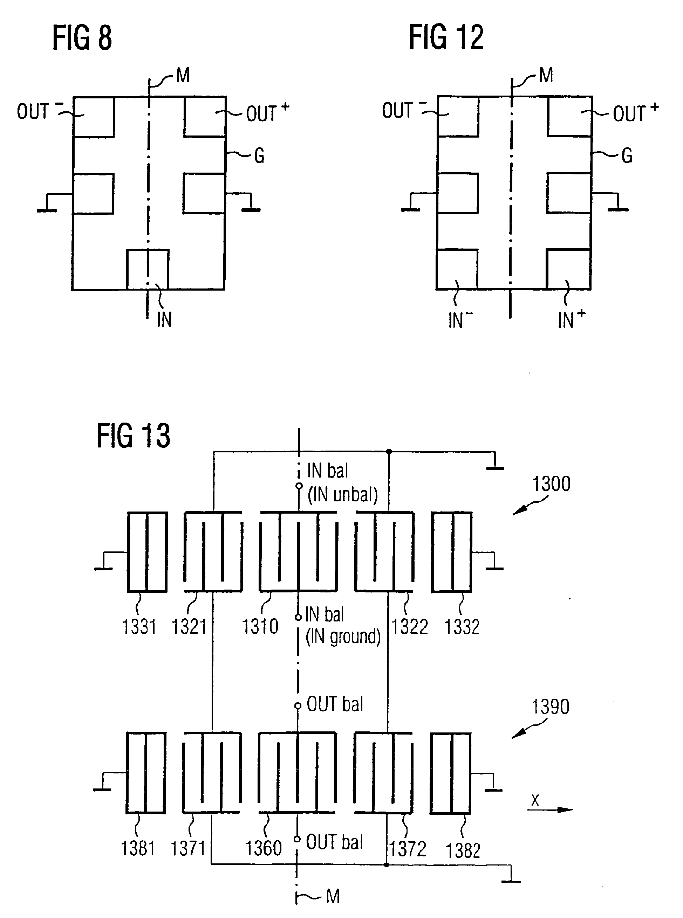

Die Figur 13 zeigt ein bekanntes kaskadiertes Filter, das zwei akustische Spuren bzw. zwei Einspur-Filter 1300, 1390 miteinander verschaltet umfasst. Bei diesem kaskadierten Filter ist beispielsweise der Wandler 1310 als wahlweise unsymmetrischer / symmetrischer Eingang des Filters vorgesehen. Die Anschlüsse des in dieser Darstellung als Ausgang verwendeten Wandlers 1360 sind symmetrische (OUT bal und OUT bal) Ausgänge. Die übrigen Wandler 1321, 1322, 1371, 1372 sind hier, wie aus der Figur ersichtlich, Koppelwandler, mit denen die beiden Spuren 1300 und 1390 elektrisch miteinander verkoppelt sind.

Wie in der Figur 13 angegeben, können diese Eingangswandler symmetrisch oder unsymmetrisch betrieben werden, mit entweder beidseitig symmetrischen Signaleingang (IN bal/IN bal) oder mit unsymmetrischem Eingang einseitig gegen Masse (IN / ground). Es sei darauf hingewiesen, dass bei einem solchen Filter Eingang und Ausgang vertauscht sein können bzw. auch vertauscht benutzt werden können.

Es ist Praxis, dass die Wandler 1310 und 1360 der Figur 13 in Bezug auf die zur Ausbreitungsrichtung x der Oberflächenwelle senkrechte Mittelebene M stets spiegelsymmetrisch ausgeführt sind und dementsprechend eine ungerade Anzahl ineinandergreifender Finger haben. In der Figur sind dies z.B. jeweils fünf interdigital angeordnete Finger der Wandler 1310 und 1360.

Bevorzugt wird diese Anordnung für nicht impedanztransformierende Filter angewendet. Die Eingangsimpedanz ist in diesem Fall gleich der Ausgangsimpedanz, $Z_{in} = Z_{out}$. Am häufigsten wird die Impedanz $Z_{in} = Z_{out} = 50\Omega$ verwendet.

In dem vorab als Beispiel erwähnten Anwendungsgebiet kommen auch differentielle Mischer mit höheren Impedanzen (z.B. $200\Omega$) zum Einsatz. Bleibt der Ausgang des Vorverstärkers (LNA) jedoch $50\Omega$, so bietet ein impedanztransformierendes Filter die optimale Lösung bezüglich der Anpassung bei minimaler Anzahl von Komponenten.

Diese Impedanztransformation kann - wie bekannt - auf zwei Arten erzeugt werden.

A) Aus dem Artikel "High Performance Balanced Type SAW Filters", von G. Endoh, M.Ueda, O. Kawachi und Y. Fujiwara, IEEE, Ultrasonics Symposium Oct. 1997, ist es bekannt, daß durch Verkleinerung der Apertur der Spur mit dem Ausgang gegenüber der Apertur der anderen Spur sich für diese eine höhere Impedanz Zout ergibt. Nachteil dieser Lösung ist eine erhöhte Einfügedämpfung (gegenüber gleichen Aperturen) wegen interner Fehlanpassung der Spuren.

B) Um z.B. in einem DMS-Filter aus vier Einzelspuren eine 1:4 Impedanztransformation zu erreichen, werden zwei Spuren am Eingang parallel und zwei Spuren am Ausgang seriell miteinander verschaltet. Nachteil ist das grosse, extrem komplexe und damit für die Fertigung sehr aufwendige (viele Bonddrähte) Layout, das eine sehr große Chipfläche benötigt.

Für die in der Praxis vorkommende Anwendung als impedanztransformierendes unsymmetrisch/symmetrisches HF-Filter vor einem symmetrischen Mischer ist die Einhaltung der geforderten Symmetrie im Durchlaßbereich des Bandpaßfilters kritisch. Verlangt wird, daß die Amplitudensymmetrie der beiden Ausgangssignale a1 und a2, definiert als $\Delta$ ampl. = ampl. (a1) - ampl. (a2) nicht größer als $\pm$ 1,0 dB ist:

$$\Delta\mathtt{ampl.} \ \le \ \pm\mathtt{1,0} \ \mathtt{dB}$$

Ebenso muß die Phasensymmetrie der beiden Ausgangssignale a1 und a2, definiert als $\Delta\phi$-180° mit $\Delta\phi = \phi$ (a1)-$\phi$(a2) im Durchlaßbereich unter 10° liegen:

$$\Delta\phi\mathtt{-180°} \ \le \ \pm\mathtt{10°}$$

Ein weiteres Kennzeichen von symmetrischen Filtern ist die hohe Stopbandunterdrückung. Im Idealfall sind die beiden symmetrischen Signale außerhalb des Durchlassbereichs in Phase und betragsmäßig gleich gross. Jede Abweichung von diesem Idealfall führt zu einer Verminderung der Signalauslöschung. Ein unerwünschtes Resetsignal ist die Folge, d.h. das Filter hat eine geringere Stopbandunterdrückung (=Selektion außerhalb des Durchlaßbereiches).

Aufgabe der vorliegenden Erfindung ist es, ein Filter anzugeben, das eine Verbesserung der Symmetrieeigenschaften im Durchlaßbereich für den Betrieb als unsymm./symm. oder symm./symm. Filter bringt, ohne den Schaltungsaufwand oder die erforderliche Chipfläche zu erhöhen.

Diese Aufgabe wird mit einem SAW-Filter nach Anspruch 1 gelöst. Vorteilhafte Ausgestaltungen der Erfindung ergeben sich aus den Unteransprüchen.

Die Erfindung basiert auf einem DMS-Filter mit zumindest einer Spur auf einem piezoelektrischen Substrat mit einer ungeraden Anzahl erster Interdigitalwandler und einer geraden Anzahl zweiter Interdigitalwandler, die mit dem Eingang bzw dem Ausgang des Filters verbunden sind und zwischen Reflektorstrukturen angeordnet sind. Bei zumindest einer akustischen Spur ist der Mittelwandler symmetrisch zur Senkrechten der Ausbreitungsrichtung der Oberflächenwelle in Teilwandler gesplittet, was zu einer geraden Anzahl von Elektrodenfingern für diesen Mittelwandler führt. Das Filter ist außerdem in symmetrischer Weise mit den Anschlußpads oder Anschlußpins eines Gehäuses verbunden, und zwar so, daß eine achsensymmetrische Anschlußbelegung gegeben ist.

Erst die Splittung des Mittelwandlers, d.h. desjenigen der ungeradzahligen ersten Interdigitalwandler, der in der Mitte der Spur angeordnet ist, erlaubt eine achsensymmetrische Anbindung an die Anschlüsse des Gehäuses, die dann auch achsensymmetrisch angeordnet sind.

Durch die geometrische Symmetrieerhöhung wird auch die Symmetrie des Übertragungsverhaltens des Filters im Durchlassbereich für die drei Fälle impedanztransformierendes unsymm./symm. Filter, impedanztransformierendes symm./symm. Filter und nicht impedanztransformierendes symm./symm. Filter verbessert.

Eine weitere Möglichkeit besteht darin, in mindestens zwei akustischen Spuren die Mittelwandler symmetrisch in Teilwandler zu splitten. Dabei ist die Summe der Fingeranzahlen der in einer akustischen Spur befindlichen gesplitteten Teilwandler gerade, während die Fingeranzahl der Teilwandler jeweils gerade oder ungerade sein kann. Vorzugsweise weisen bei kaskadierten erfindungsgemäßen Mehrspurfiltern die beiden äußeren mit Ein- oder Ausgang verbundenen Spuren gesplittete Mittelwandler auf. Bei einem symmetrisch/symmetrisch betriebenen Filter führt das zu einer weiteren Verbesserung des Übertragungsverhaltens.

Von Vorteil für ein symmetrisches Übertragungsverhalten ist weiterhin, wenn die Anbindung an das Gehäuse über Bumpverbindungen vorgenommen ist. Damit werden Unsymmetrien durch parasitäre Kapazitäten und Induktivitäten vermieden, die die Folge von oft unterschiedlich langen Bonddrähten sein können, was sich bei Draht-Bondung praktisch nicht vermeiden läßt. In der Folge ist das Filter vorzugsweise durch Flip-Chip-Technik in das Gehäuse eingebaut. Bumpverbindungen lassen sich regelmäßiger herstellen und erzeugen grundsätzlich geringere parasitäre Kapazitäten und Induktivitäten.

Von Vorteil ist es, wenn auch nicht gesplittete Mittelwandler oder andere Interdigitalwandler eine gerade Anzahl von Elektrodenfingern aufweisen.

Bei unsymmetrisch/symmetrischer Betriebsweise des Filters weist das unsymmetrische Tor (Ein- oder Ausgang) einen einzigen signalführenden Anschluß und einen dazugehörigen Masseanschluß auf. Das symmetrische Tor hat zwei signalführende Anschlüsse. Dafür ist ein ideal symmetrisches Gehäuse mit fünf Anschlüssen (davon drei signalführende Anschlüsse) vorteilhaft, wobei das Anschlußpad für den signalführenden Anschluß am unsymmetrischen Tor auf der Symmetrieachse und die Anschlußpads für die paarweise vorhandenen Anschlüsse am symmetrischen Tor und für die Masse jeweils symmetrisch zur Symmetrieachse liegen. Zwei Masseanschlüsse haben den Vorteil, daß die Masseanbindung vom Chip zum Gehäuse und nach außen auch symmetrisch gestaltet werden kann.

Bei symmetrisch/symmetrischer Betriebsweise des Filters mit jeweils paarweise vorhandenen Anschlüssen ist ein ideal symmetrisches Gehäuse mit sechs Anschlüssen von Vorteil, wobei jeweils zwei Anschlußpads für die Masse, Ein- und Ausgang symmetrisch zur Symmetrieachse angeordnet sind.

Vorzugsweise sind die Anschlußpads für die Masse zwischen den Anschlußpads für Ein- und Ausgang angeordnet. Dies ermöglicht eine bessere kapazitive Trennung und vermindert so die nicht gewünschte Kopplung von Ein- und Ausgang (direktes Übersprechen).

In einer Ausführung der Erfindung sind die Anschlußpads für Masse zu einem gemeinsamen, zur Symmetrieachse symmetrischen Pad zusammengefaßt.

Zur Anpassung an eine Schaltungsumgebung kann das Filter Impedanz angepasst und insbesondere Impedanz transformierend sein. Diese Maßnahmen können bei einem erfindungsgemäßen Filter in an sich bekannter Weise vorgenommen werden. Vorzugsweise liegt der Impedanztransformationsfaktor bei 1:4. Bei Verwendung verschiedener Aperturen in den beiden Spuren (siehe Variante A) sind auch modifizierte Impedanztransformationsfaktoren möglich, jedoch erhöht sich dabei wie bereits erwähnt die Einfügedämpfung.

Im folgenden wird die Erfindung an Hand von Ausführungsbeispielen und der dazugehörigen 14 Figuren näher erläutert. Diese zeigen in teils schematischer und nicht maßstabsgetreuer Darstellung:

Figur 1    ein erfindungsgemäßes impedanztransformiertes Filter in unsymm./symm. Betriebsweise

Figur 2    eine Variante von Figur 1 mit veränderter Elektrodenfingeranzahl

Figur 3     die Meßkurve für die Amplitudensymmetrie eines Filters nach Figur 2

Figur 4     die Meßkurve für die Phasensymmetrie eines Filters nach Figur 2

Figur 5     ein impedanztransformiertes Filter in symm./ symm. Betriebsweise

Figur 6     ein nicht impedanztransformiertes Filter in unsymm./symm. Betriebsweise

Figur 7     ein nicht impedanztransformiertes Filter in symm./symm. Betriebsweise

Figur 9     ein erfindungsgemäßes Filter in unsymm./ symm. Betriebsweise mit einer DMS Spur

Figur 8     ein Gehäuse mit symmetrischer Anschlußfolge

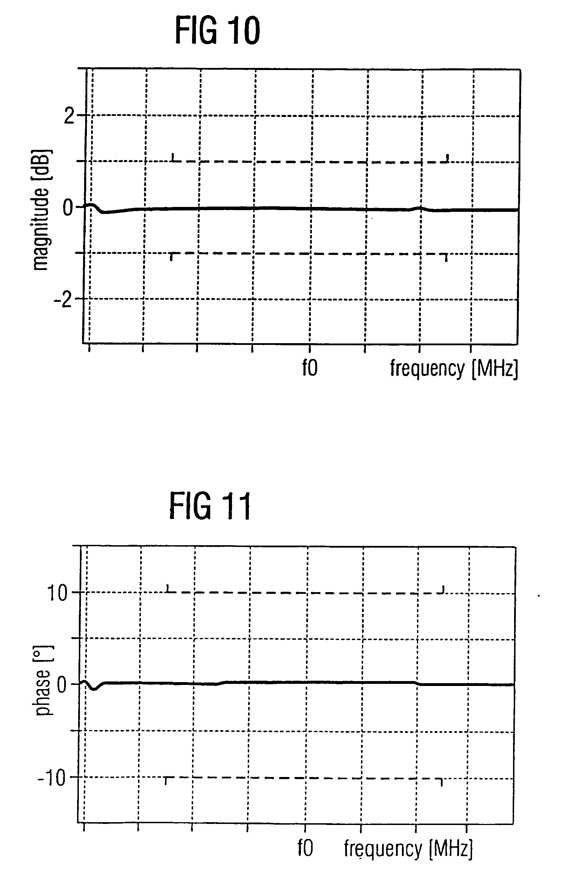

Figur 10     eine Meßkurve für die Amplitudensymmetrie eines Filters im erfindungsgemäßen Gehäuse

Figur 11     die entsprechende Meßkurve für die Phasensymmetrie

Figur 12     ein Gehäuse mit symmetrischer Anschlußfolge und

Figur 13     ein bekanntes 2-Spur DMS-Filter.

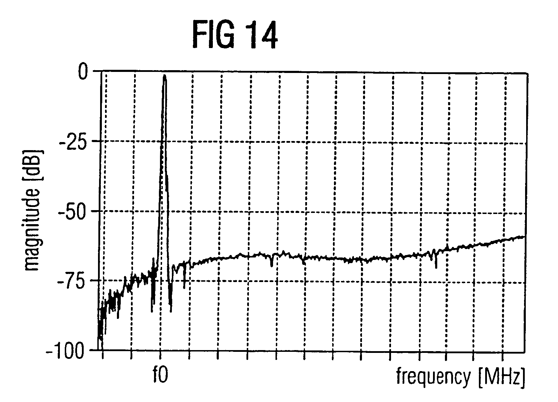

Figur 14     eine Durchlaßkurve eines erfindungsgemäßen Filters

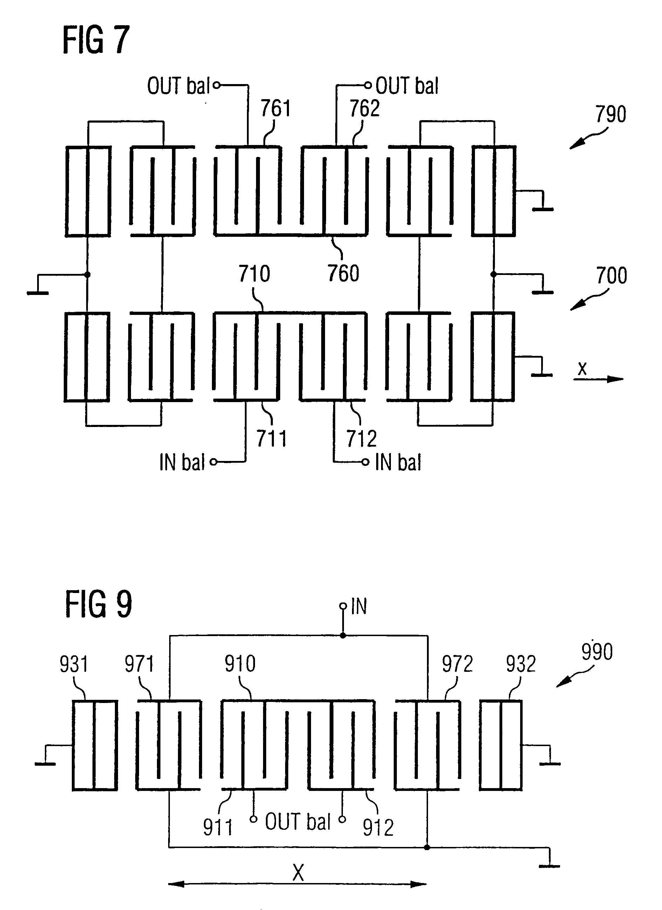

Figur 9 zeigt das Prinzip der Erfindung anhand einer DMS Spur 990 mit einem ersten, als Ausgang dienenden, in zwei Teilwandler 911, 912 gesplitteten Mittelwandler 910 und zwei zweiten, als Eingang dienenden Wandlern 971, 972. Die Wandler sind in der Spur beidseitig von Reflektoren 931,932 begrenzt. Die Symmetrieachse M steht senkrecht zur Ausbreitungsrichtung X der Oberflächenwelle und teilt den Mittelwandler 910, der ein erster Interdigitalwandler ist, symmetrisch. Die dargestellte Struktur kann bereits als Filter dienen, wird jedoch vorzugsweise mit zumindest einer weiteren DMS Spur kaskadiert. Dabei können die Ausgänge der ersten oder zweiten Spur mit den Eingängen der zweiten oder ersten Spur verbunden werden. Generell können auch Ein- und Ausgänge vertauscht sein, das Filter also in die andere Richtung betrieben werden. Möglich ist es auch, seriell zu dem oder den Einoder Ausgängen weitere Elemente zu schalten, wie z.B. Resonatoren. Solche vorzugsweise verwendeten mehrspurigen DMS Filter sind in den folgenden Ausführungsbeispielen beschrieben.

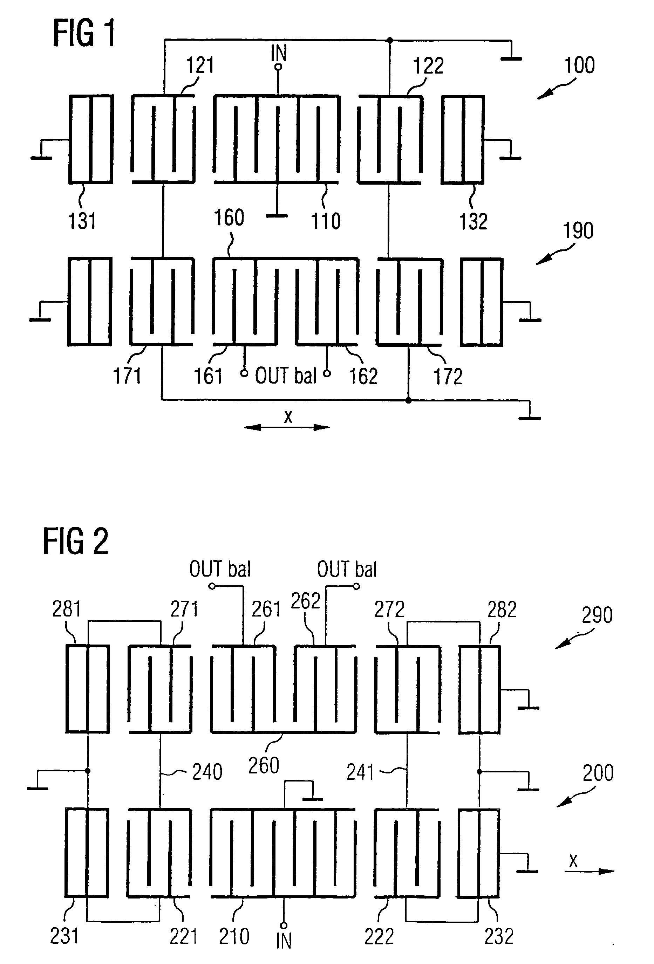

**Beispiel 1:** Impedanztransformierendes unsymm./ symm. Filter mit verbesseruter Symmetrie im Durchlassbereich (Figuren 1 und 2)

In Figur 1 ist das Prinzip des nach der Form benannten V-Splits dargestellt. Der Ausgangswandler 160 ist in zwei Teilwandler 161 und 162 gesplittet. Diese werden elektrisch so miteinander verbunden, daß eine Serienschaltung der Teilwandler bezüglich der Anschlüsse des Filterausgangs entsteht. Daraus ergibt sich eine Vervierfachung der Impedanz, da sowohl die Wandlerhalbierung als auch die Serienschaltung jeweils eine Verdopplung der Impedanz nach sich zieht. Die Lage der Anschlüsse ermöglicht einen symmetrischen Anschluß bzw. Einbau in ein symmetrisches Gehäuse. Die (nicht dargestellte) Symmetrieachse steht senkrecht zur Ausbreitungsrichtung X der Oberflächenwelle und teilt die beiden Mittelwandler 110 und 160 symmetrisch.

In einer in Figur 2 dargestellten Variante zu der von Figur 1 wird auf der unsymm. Seite eine gerade Fingeranzahl für den mittleren Wandler 210 verwendet. In der Ausgangsspur wird der Koppelwandler 271 um die Achse x, in der die Wellenausbreitung stattfindet, geklappt. Das heisst, alle vier Koppelwandler (221, 222, 271, 272) haben eine gleiche Ausrichtung zum mittleren Wandler 210 oder 260 hin, mit dem dem mittleren Wandler am nächsten liegenden ersten Finger. Im dargestellten Beispiel ist die Ausführung so gewählt, dass diese ersten Finger an den Koppelpads 240 und 241 zwischen den Spuren angeschlossen sind.

Die Anzahl der Finger in den Koppelwandlern (221, 222, 271, 272) kann gerad- oder ungeradzahlig sein. In der gezeigten Anordnung findet die Kopplung zwischen den Spuren im Gegentakt statt, d.h. mit entgegengesetzter Phasenlage in den Koppelpads 240 und 241. Die Anzahl der Finger in den gesplitteten Teilwandlern 261 und 262 in der Spur 290 ist üblicherweise gleich der halben Fingerzahl im Mittelwandler 210 der Spur 200. Die Fingerzahl im Eingangswandler 210 ist gerade.

Die Koppelwandler 221, 222, 271, 272 können an der äußeren, nicht mit einem Koppelpad 240, 241 verbundenen Seite mit Masse verbunden sein. Möglich ist es jedoch auch, die einander benachbarten Koppelwandler zweier benachbarter Spuren an der äußeren Seite miteinander zu verbinden.

Die Reflektoren (231, 232, 281, 282) an den Spuren können floatend ausgebildet oder mit der Masse verbunden sein.

Es ist auch wie dargestellt ein Anschluss der Reflektoren an einen Anschluss der äusseren, angrenzenden Koppelwandler möglich. Der Anschluss kann, anders als in Fig. 2 dargestellt, auch so erfolgen, dass der Reflektor auf genau dem entgegengesetzten Potential zum letzten, angrenzenden Wandlerfinger liegt.

Ein- und Ausgang können bzgl. der Anordnung der akustischen Spuren auch vertauscht sein, was im übrigen für alle erfindungsgemäßen Filter gilt.

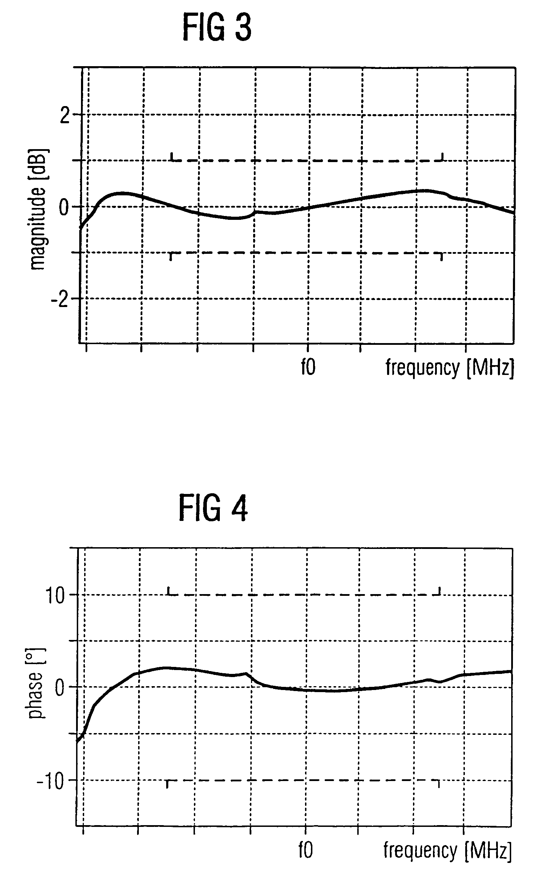

Durch die Fingeranordnung gemäss Figur 2 wird die Symmetrie im Durchlaßbereich gegenüber den bisherigen Anordnungen deutlich verbessert. Der Wert für die typische Amplitudensymmetrie reduziert sich dabei auf typ. $\pm 0,3$ dB und der Wert für die Phasensymmetrie auf typ. $\pm 2°$. Das Symmetrieverhalten dieses Filters ist bezüglich Amplitudensymmetrie in Figur 3 und bezüglich Phasensymmetrie in Figur 4 dargestellt. Aufgetragen ist jeweils der Differenzwert der beiden Signale a1 und a2 gegen die Frequenz f.

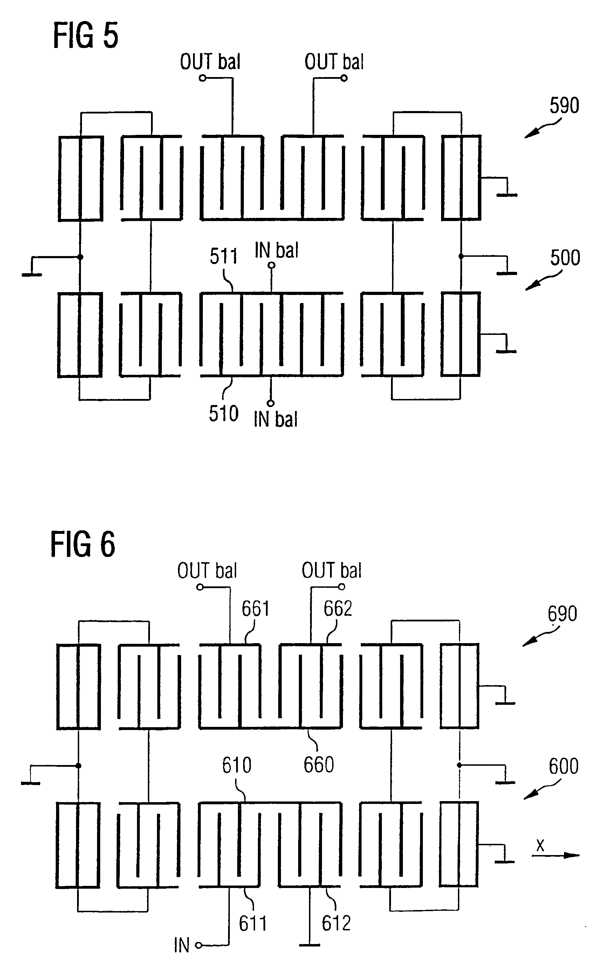

**Beispiel 2:** Impedanztransformierendes symm./symm. Filter (Figur 5)

Die Figur 5 ist mit Beispiel 1 bezüglich der layoutmässigen Anordnung identisch, bis auf den zweiten isoliert herausgeführten Anschluss 511 des mittleren Wandlers 510 der Eingangsspur. Dieser wird im Gegensatz zur Ausführung 1 nicht auf Masse gelegt, sondern dient als zweiter Anschluss für das symmetrische Signal auf der niederohmigen Filterseite. Die Verbesserung der Symmetrie im Durchlaßbereich ist vergleichbar mit den Ergebnissen der Ausführung 1.

**Beispiel 3:** Nicht impedanztransformierendes unsymm./ symm. Filter (Figur 6)

In dieser Ausführungsform werden die mittleren Wandler 610 und 660 der beiden Spuren geteilt und in Serie geschaltet, jedoch nur in einer Spur symmetrisch betrieben. In der zweiten Spur ist einer der beiden Teilwandler mit dem Signal belegt und der zweite Teilwandler wird auf Masse gelegt, die Spur ist also unsymmetrisch betrieben.

**Beispiel 4**: Nicht impedanztransformierendes symm./ symm. Filter (Figur 7)

In einer vierten Ausführungsform wird der mittlere Wandler 710 und 760 in beiden Spuren geteilt und in Serie geschaltet. Damit lassen sich beidseitig symm. betreibbare Filter hoher Selektion bevorzugt ohne impedanztransformierende Wirkung realisieren.

Durch Unterschiede in den Aperturen der beiden Spuren 600/690 bzw. 700/790 lassen sich die Beispiele 3 und 4 auch in impedanztransformierende Filter abwandeln.

Durch die für den Idealfall nahezu identischen Signale vom Eingang zum Ausgang lassen sich insbesondere für die Beispiele 1 und 4 sehr hohe Selektionen erzielen. Im Durchlassbereich führt die noch symmetrischere Ansteuerung der gesplitteten Teilwandler zur gewünschten Verbesserung der Amplituden- und Phasensymmetrie: (siehe Figur 3 und 4).

Amplitudendiferenz: $< \pm$ 0,3 dB typ.
Phasendifferenz: $< \pm$ 2° typ.

Auch für den Sperrbereich hat die Verbesserung der Symmetrie der akustischen Spuren gemäß Ausführung 1-4 einen Vorteil: die Unterdrückung im Stopband wird durch die verbesserte Auslöschung der symm. Signale erhöht, was durch die Wahl eines entsprechend symmetrischen Gehäuses unterstützt wird.

Nachfolgend werden für die Ausführungen 1+4 die darauf abgestimmten Gehäuse- und Verbindungstechniken beschrieben.

**Beispiel 5:** Gehäuse für impedanztransformierendes unsymm./symm. Filter (Figur 8)

Ein DMS-Filter nach Figur 2 besteht aus zwei akustischen Spuren 200 und 290, wobei die Eingangsspur unsymm. und die Ausgangsspur symmetrisch angeschlossen ist. Die beiden Spuren sind parallel angeordnet und die Symmetrieachse liegt senkrecht zur Ausbreitungsrichtung x der beiden Spuren. Die beiden Anschlüsse der Eingangsspur (IN und Masse) liegen auf der Symmetrieachse M, die beiden symmetrischen Anschlüsse der Ausgangsspur (OUT bal) liegen symm. zur Symmetrieachse, was nur durch die erfindungsgemäße Verwendung eines V-Split Wandlers möglich ist. Um eine maximal gute Entkopplung zwischen Ein- und Ausgangssignal zu erhalten, wird bei der Eingangsspur das Massepad des Eingangswandlers zwischen die beiden akustischen Spuren gelegt und das Pad des heissen Eingangssignals (IN) nach außen orientiert. Dadurch ist der Abstand der Signalpads von Ein- und Ausgang bezogen auf die Chipgröße maximal und die Massefläche zwischen den akustischen Spuren erzeugt eine weitere Entkopplung der Signale. Der Masseanschluß der Reflektoren kann auch zwischen den akustischen Spuren erfolgen.

Das Gehäuse G bekommt nun ein entsprechendes Layout (siehe Figur 8), d.h. das Eingangslötpad (IN) liegt auf der Symmetrieachse an dem einen Ende des Gehäuses und die Ausgangslötpads (OUT- und OUT+) liegen symm. zur Symmetrieachse M am anderen Ende des Gehäuses. In der Mitte sind die Masselötpads angeordnet. Die gehäuseinternen Verbindungswege sind ebenfalls absolut symmetrisch gestaltet, so dass ein ideal symmetrisches Gesamtlayout erreicht wird. Somit addieren sich erfindungsgemäß drei Faktoren, die bereits für sich, vor allem aber in ihrer synergistischen Wirkung im Filter eine gute Sperrbereichsunterdrückung bewirken:

- absolute Symmetrie des Chiplayouts
- absolute Symmetrie des Gehäuselayouts
- maximale Entkopplung zwischen Ein- und Ausgang durch die dazwischenliegende Masse sowohl auf dem Chip als auch im Gehäuse

Figur 14 zeigt die gemessene Übertragungsfunktion eines Filters bei ca 1GHz, das in einem entsprechenden Gehäuse realisiert wurde. Die Stopbandunterdrückung beträgt typ. >65dB oberhalb des Durchlaßbereiches.

Auch die Symmetrie im Durchlassbereich wird durch das ideal symmetrische Gehäuse mit den durch die Bumpverbindungen stark reduzierten, in den symmetrischen Pfaden gleichmäßigen und gut reproduzierbaren Induktivitäten nochmals verbessert. Das symmetrische Signal, das durch die Akustik sehr rein erzeugt wird, wird auf seinem Weg auf dem Chip und durch das Gehäuse nahezu nicht mehr in seiner Symmetrie gestört.

Figur 10 und 11 zeigt die im Durchlassbereich nahezu ungestörte Symmetrie eines DMS-Filters, das gemäß der Erfindung eine verbesserte Symmetrie in den akustischen Spuren aufweist und in das eben beschriebene 5-pinnige Gehäuse eingebaut wurde. Durch diese Kombination erreicht man eine typische Amplitudensymmetrie (Figur 10) von

$$\Delta \text{ ampltyp} < \pm 0,1 \text{ dB}$$

und eine typische Phasensymmetrie (Figur 11) von

$$\Delta \varphi \text{typ} -180° < \pm 0,5°.$$

**Beispiel 6:** Gehäuse für nicht impedanztransformierendes symm./symm. Filter (Figur 12)

Die beiden Spuren eines DMS-Filter, beispielsweise eines Filters gemäß Figur 7, sind parallel angeordnet und die Symmetrieachse M liegt senkrecht zur Ausbreitungsrichtung x der beiden Spuren. Die beiden symmetrischen Anschlüsse der Eingangsspur (IN bal) liegen ebenso wie die beiden symmetrischen Anschlüsse der Ausgangsspur (OUT bal) durch die zweifache Verwendung eines V-Splits symm. zur Symmetrieachse. Um eine maximal gute Entkopplung zwischen Ein- und Ausgangssignal zu erhalten, wird der Masseanschluß für die Reflektoren zwischen die beiden akustischen Spuren gelegt und die Pads der heissen Eingangs- und Ausgangssignale jeweils nach außen orientiert. Dadurch ist der Abstand der Signalpads von Ein- und Ausgang bezogen auf die Chipgröße maximal und die Massefläche zwischen den akustischen Spuren erzeugt eine weitere Entkopplung der Signale.

Das Gehäuse G bekommt nun ein entsprechendes Layout, d.h. die Eingangslötpads (IN- und IN+) liegen symm. zur Symmetrieachse M an dem einen Ende des Gehäuses und die Ausgangslötpads (OUT- und OUT+) liegen symm. zur Symmetrieachse am anderen Ende des Gehäuses. In der Mitte sind die Masselötpads angeordnet. Die gehäuseinternen Verbindungswege werden ebenfalls absolut symmetrisch gestaltet, so dass Filter samt Gehäuse ein ideal symmetrisches Gesamtlayout mit entsprechenden guten Ergebnissen ergeben.

Eine weitere Ursache für Unsymmetrien kann in Fertigungsstreuungen bei den elektrischen Anschlüssen liegen, wie es bei Bonddrähten (unterschiedliche Länge) fast nicht zu vermeiden ist. Aus diesem Grund wird bei den Gehäusen in den Ausführungen 5 und 6 als Verbindungstechnik vorzugsweise die Bumptechnologie verwendet. Deren Induktivitäten sind sehr klein und auch gut reproduzierbar. Der Chip wird dabei kopfüber mittels sogenannter Bumps oder Lotkugeln mit dem Gehäuse verlötet. Auf diese Weise sind die Unsymmetrien durch Schwankungen der Verbindungsinduktivitäten auf ein Minimum reduziert bzw. vernachlässigbar.

Bezugszeichenliste

Für die jeweilige Figur "x" gilt:

| | |
|---|---|
| x10 | Mittelwandler/Eingang |
| x60 | Mittelwandler/Ausgang |
| x11 | Teilwandler von x10 |
| x12 | Teilwandler von x10 |
| x61 | Teilwandler von x60 |
| x62 | Teilwandler von x60 |
| x21 | Koppelwandler/Eingangsspur |
| x22 | Koppelwandler/Eingangsspur |
| x71 | Koppelwandler/ Ausgangsspur |
| x72 | Koppelwandler/ Ausgangsspur |
| x31 | Reflektoren/Eingangsspur |
| x32 | Reflektoren/Eingangsspur |
| x81 | Reflektoren/ Ausgangsspur |
| x82 | Reflektoren/ Ausgangsspur |
| x00 | Spur/Eingang |
| x90 | Spur/Ausgang |
| X | Ausbreitungsrichtung der OFW |
| M | Symmetrieachse/-ebene |
| G | Gehäuse |

**Patentansprüche**

1. SAW-Filter nach dem DMS-Filtertyp,

   - mit zumindest einer auf einem piezoelektrischen Substrat ausgebildeten akustischen Spur, welche eine Anzahl von n. ersten Interdigitalwandlern (910) als Signaleingang oder -ausgang und n+1 zweiten Interdigitalwandlern (971,972) als Signalausgang oder -eingang aufweist, wobei $n \in N$, und wobei diese Interdigitalwandler sich zwischen mindestens zwei die akustische Spur begrenzenden Reflektorstrukturen (931,932) befinden,
   - bei dem mindestens eine akustische Spur (990) einen symmetrisch zur Senkrechten (M) der Ausbreitungsrichtung (x) in Teilwandler (911,912) gesplitteten Mittelwandler (910) besitzt;
   - welches in zur genannten Senkrechten (M) symmetrischer Weise mit einem ideal symmetrischen Gehäuse (G), dessen gehäuseinterne Verbindungswege absolut symmetrischzur zur Senkrechten (M) gestaltet sind, mit Anschlußpads oder Anschlußpins verbunden ist, so daß eine.achsensymmetrische Anschlußbelegung auf dem Substrat und im Gehäuse gegeben ist.

2. SAW-Filter nach Anspruch 1,

- mit zumindest zwei auf einem piezoelektrischen Substrat ausgebildeten akustischen Spuren, welche Spuren jeweils eine Anzahl von n mit n∈N ersten Interdigitalwandlern (110,160) als Signaleingang oder -ausgang und n+1 zweiten Interdigitalwandlern (121,122; 171,172) als Koppelwandler aufweist und diese Interdigitalwandler sich zwischen mindestens zwei die akustische Spur begrenzenden Reflektorstrukturen (131,132) befinden,
- bei dem mindestens eine akustische Spur (190) einen symmetrisch zur Senkrechten (M) der Ausbreitungsrichtung (x) in Teilwandler (161,162) gesplitteten Mittelwandler (160) besitzt,
- welches in symmetrischer Weise mit einem Gehäuse (G) mit Anschlußpads oder Anschlußpins verbunden ist, so daß eine achsensymmetrische Anschlußbelegung gegeben ist.

3. SAW-Filter nach Anspruch 1 oder 2, bei dem mindestens zwei akustische Spuren (600,690) einen symmetrisch zur Senkrechten (M) der Ausbreitungsrichtung (x) in Teilwandler (611,612,661,662) gesplitteten Mittelwandler (610,660) besitzen und jeweils die Summe der Fingeranzahl der in einer akustischen Spur (600,690) befindlichen gesplitteten Teilwandler gerade ist, und die Fingeranzahl der Teilwandler jeweils gerade oder ungerade ist.

4. SAW-Filter nach einem der Ansprüche 1-3, bei welchem die Anbindung an das Gehäuse (G) eine Bumpverbindung umfaßt.

5. SAW-Filter nach einem der Ansprüche 1-4, welches durch Flip-Chip-Technik in das Gehäuse (G) eingebaut ist.

6. SAW-Filter nach einem der Ansprüche 1-5, bei dem die zweiten Interdigitalwandler (210,510) eine gerade Anzahl von Elektrodenfingern aufweisen.

7. SAW-Filter nach einem der Ansprüche 1-6, (2)bei dem mindestens eine akustische Spur (190) genau einen in zwei Teilwandler (161,162) gesplitteten Mittelwandler (160), zwei Koppelwandler (171,172) und je mindestens eine endständige Reflektorstruktur (181,182) aufweist.

8. SAW-Filter nach einem der Ansprüche 1-7 bei dem nicht gesplittete Mittelwandler (210,510) eine gerade Anzahl von Elektrodenfingern aufweisen.

9. SAW-Filter nach einem der Ansprüche 1-8, das in ein ideal symmetrisches Gehäuse (G) mit fünf Anschlüssen eingebaut ist, wobei das Anschlußpad für den Eingang auf der Symmetrieachse (M) und die Anschlußpads für den Ausgang und die Masse jeweils symmetrisch zur Symmetrieachse liegen.

10. SAW-Filter nach einem der Ansprüche 1-8, das in ein ideal symmetrisches Gehäuse (G) mit sechs Anschlüssen eingebaut ist, wobei die Anschlußpads für die Masse symmetrisch zur Symmetrieachse (M) zwischen den Anschlußpads für Ein- und Ausgang angeordnet sind.

11. SAW-Filter nach einem der Ansprüche 1-10 bei dem die beiden Masselötpads zu einem gemeinsamen, zur Symmetrieachse symmetrischen Pad zusammengefaßt sind.

12. SAW-Filter nach einem der Ansprüche 1-11 bei dem die Masselötpads zwischen den Ein- und Ausgangspads angeordnet sind.

13. SAW-Filter nach einem der Ansprüche 1-12 bei welchem die Gesamtfiltergröße kleiner oder gleich 3. 0x3 . 0mm$^2$ ist.

14. SAW-Filter nach einem der Ansprüche 1-13 bei welchem die Gesamtfiltergröße kleiner oder gleich 2.0x2.5 mm$^2$ ist.

15. SAW-Filter nach einem der Ansprüche 1-14, welches eine Impedanztransformation aufweist.

16. SAW-Filter nach Anspruch 15, bei dem die Impedanztransformation das Verhältnis 1:4 aufweist.

17. SAW-Filter nach Anspruch 15 oder 16, welches für eine Impedanztransformation von 50/150Ω oder 50/200Ω ausgelegt ist.

18. SAW-Filter nach einem der Ansprüche 1-14, welches mit einer Impedanz von 200/200Ω abgeschlossen ist.

19. Anwendung eines SAW-Filters nach einem der vorangehenden Ansprüche in unsymmetrisch/symmetrischer Betriebsweise.

20. Anwendung eines SAW-Filters nach einem der vorangehenden Ansprüche in symmetrisch/symmetrischer Betriebsweise.

**Claims**

1. SAW filter according to the DMS filter type,

   - comprising at least one acoustic track which is formed on a piezoelectric substrate and has a number of n first interdigital transducers (910) as signal input or output and n+1 second interdigital transducers (971, 972) as signal output or input, wherein n∈ N, and wherein said interdigital transducers are situated between at least two reflector structures (931, 932) delimiting the acoustic track,
- wherein at least one acoustic track (990) has a centre transducer (910) split into partial transducers (911, 912) symmetrically with respect to the perpendicular (M) to the propagation direction (x),
- which filter, symmetrically with respect to said perpendicular (M), is connected to an ideally symmetrical housing (G), the housing-internal connecting paths of which are fashioned absolutely symmetrically with respect to the perpendicular (M), with connection pads or connection pins, thus resulting in an axially symmetrical connection assignment on the substrate and in the housing.

2. SAW filter according to Claim 1,

- comprising at least two acoustic tracks which are formed on a piezoelectric substrate, which tracks each have a number of n where n∈ N first interdigital transducers (110, 160) as signal input or output and n+1 second interdigital transducers (121, 122; 171, 172) as coupling transducers and these interdigital transducers are situated between at least two reflector structures (131, 132) delimiting the acoustic track,
- wherein at least one acoustic track (190) has a centre transducer (160) split into partial transducers (161, 162) symmetrically with respect to the perpendicular (M) to the propagation direction (x),
- which filter is connected symmetrically to a housing (G) with connection pads or connection pins, thus resulting in an axially symmetrical connection assignment.

3. SAW filter according to Claim 1 or 2, wherein at least two acoustic tracks (600, 690) have a centre transducer (610, 660) split into partial transducers (611, 612, 661, 662) symmetrically with respect to the perpendicular (M) to the propagation direction (x), and the sum of the number of fingers of the split partial transducers situated in an acoustic track (600, 690) is in each case even, and the number of fingers of the partial transducers is in each case even or odd.

4. SAW filter according to any of Claims 1-3, wherein the linking to the housing (G) comprises a bump connection.

5. SAW filter according to any of Claims 1-4, which is incorporated into the housing (G) by flip-chip technology.

6. SAW filter according to any of Claims 1-5, wherein the second interdigital transducers (210, 510) have an even number of electrode fingers.

7. SAW filter according to any of Claims 1-6, wherein at least one acoustic track (190) has exactly one centre transducer (160) split into two partial transducers (161, 162), two coupling transducers (171, 172) and respectively at least one reflector structure (181, 182) at the end.

8. SAW filter according to any of Claims 1-7, wherein non-split centre transducers (210, 510) have an even number of electrode fingers.

9. SAW filter according to any of Claims 1-8, which is incorporated into an ideally symmetrical housing (G) with five connections, wherein the connection pad for the input lies on the axis (M) of symmetry and the connection pads for the output and ground are in each case symmetrical with respect to the axis of symmetry.

10. SAW filter according to any of Claims 1-8, which is incorporated into an ideally symmetrical housing (G) with six connections, wherein the connection pads for ground are arranged symmetrically with respect to the axis (M) of symmetry between the connection pads for input and output.

11. SAW filter according to any of Claims 1-10, wherein the two ground soldering pads are combined to form a common pad that is symmetrical with respect to the axis of symmetry.

12. SAW filter according to any of Claims 1-11, wherein the ground soldering pads are arranged between the input and output pads.

13. SAW filter according to any of Claims 1-12, wherein the total filter size is less than or equal to $3.0 \times 3.0$ mm$^2$.

14. SAW filter according to any of Claims 1-13, wherein the total filter size is less than or equal to $2.0 \times 2.5$ mm$^2$.

15. SAW filter according to any of Claims 1-14, which has an impedance transformation.

16. SAW filter according to Claim 15, wherein the impedance transformation has the ratio 1:4.

**17.** SAW filter according to Claim 15 or 16, which is designed for an impedance transformation of 50/1505Ω or 50/200Ω.

**18.** SAW filter according to any of Claims 1-14, which is terminated with an impedance of 200/200Ω.

**19.** Use of a SAW filter according to any of the preceding claims in unbalanced/balanced mode of operation.

**20.** Use of a SAW filter according to any of the preceding claims in balanced/balanced mode of operation.

**Revendications**

**1.** Filtre SAW selon le principe du filtre DMS

- comprenant au moins une piste acoustique configurée sur un substrat piézoélectrique, laquelle présente un nombre n de premiers convertisseurs interdigitaux (910) faisant office d'entrée ou de sortie de signal et un nombre n+1 de deuxièmes convertisseurs interdigitaux (971, 972) faisant office de sortie ou d'entrée de signal, dans lequel *n∈ N* et dans lequel ces convertisseurs interdigitaux se trouvent entre au moins deux structures réflectrices (931, 932) qui délimitent la piste acoustique,
- dans lequel au moins une piste acoustique (990) possède un convertisseur central (910) fractionné en convertisseurs partiels (911, 912) symétriquement par rapport à la verticale (M) du sens de la propagation (x),
- lequel est relié, de manière symétrique par rapport à ladite verticale (M), avec un boîtier (G) idéalement symétrique muni de pastilles de raccordement ou de broches de raccordement et dont les chemins de liaison internes au boîtier sont configurés de manière parfaitement symétrique par rapport à la verticale (M), ce qui permet d'obtenir une affectation des bornes symétrique à l'axe sur le substrat et dans le boîtier.

**2.** Filtre SAW selon la revendication 1,

- comprenant au moins deux pistes acoustiques configurées sur un substrat piézoélectrique, lesquelles pistes présentent respectivement un nombre n, avec *n∈ N,* de premiers convertisseurs interdigitaux (110, 160) faisant office d'entrée ou de sortie de signal et un nombre n+1 de deuxièmes convertisseurs interdigitaux (121, 122 ; 171, 172) faisant office de convertisseurs de couplage et ces convertisseurs interdigitaux se trouvent entre au moins deux structures réflectrices (131, 132) qui délimitent la piste acoustique,

- dans lequel au moins une piste acoustique (190) possède un convertisseur central (160) fractionné en convertisseurs partiels (161, 162) symétriquement par rapport à la verticale (M) du sens de la propagation (x),
- lequel est relié, de manière symétrique, avec un boîtier (G) muni de pastilles de raccordement ou de broches de raccordement, ce qui permet d'obtenir une affectation des bornes symétrique à l'axe.

**3.** Filtre SAW selon la revendication 1 ou 2, dans lequel au moins deux pistes acoustiques (600, 690) possèdent un convertisseur central (610, 660) fractionné en convertisseurs partiels (611, 612, 661, 662) symétriquement par rapport à la verticale (M) du sens de la propagation (x) et la somme du nombre de doigts des convertisseurs partiels fractionnés qui se trouvent dans une piste acoustique (600, 690) est à chaque fois paire, et le nombre de doigts des convertisseurs partiels est à chaque fois pair ou impair.

**4.** Filtre SAW selon l'une des revendications 1 à 3, dans lequel le rattachement au boîtier (G) comprend une liaison par bosse.

**5.** Filtre SAW selon l'une des revendications 1 à 4, lequel est intégré dans le boîtier (G) par la technique de la puce retournée.

**6.** Filtre SAW selon l'une des revendications 1 à 5, dans lequel les deuxièmes convertisseurs interdigitaux (210, 510) présentent un nombre pair de doigts d'électrode.

**7.** Filtre SAW selon l'une des revendications 1 à 6, dans lequel au moins une piste acoustique (190) présente exactement un convertisseur central (160) fractionné en deux convertisseurs partiels (161, 162), deux convertisseurs de couplage (171, 172) et à chaque fois au moins une structure réflectrice (181, 182) autonome.

**8.** Filtre SAW selon l'une des revendications 1 à 7, dans lequel les convertisseurs centraux (210, 510) non fractionnés présentent un nombre pair de doigts d'électrode.

**9.** Filtre SAW selon l'une des revendications 1 à 8, lequel est intégré dans un boîtier (G) idéalement symétrique muni de cinq bornes, la pastille de raccordement pour l'entrée se trouvant sur l'axe de symétrie (M) et les pastilles de raccordement pour la sortie et pour la masse étant respectivement disposées symétriquement par rapport à l'axe de symétrie.

**10.** Filtre SAW selon l'une des revendications 1 à 8, lequel est intégré dans un boîtier (G) idéalement symétrique muni de six bornes, les pastilles de raccordement pour la masse étant disposées symétriquement par rapport à l'axe de symétrie (M) entre les pastilles de raccordement pour l'entrée et la sortie.

11. Filtre SAW selon l'une des revendications 1 à 10, dans lequel les pastilles à braser de masse sont assemblées en une pastille commune, symétrique par rapport à l'axe de symétrie.

12. Filtre SAW selon l'une des revendications 1 à 11, dans lequel les deux pastilles à braser de masse sont disposées entre les pastilles d'entrée et de sortie.

13. Filtre SAW selon l'une des revendications 1 à 12, dans lequel la taille totale du filtre est inférieure ou égale à 3,0 x 3,0 mm$^2$.

14. Filtre SAW selon l'une des revendications 1 à 13, dans lequel la taille totale du filtre est inférieure ou égale à 2,0 x 2,5 mm$^2$.

15. Filtre SAW selon l'une des revendications 1 à 14, lequel présente une transformation d'impédance.

16. Filtre SAW selon la revendication 15, dans lequel la transformation d'impédance présente le rapport 1:4.

17. Filtre SAW selon la revendication 15 ou 16, lequel est conçu pour une transformation d'impédance de 50/150 Ω ou de 50/200 Ω.

18. Filtre SAW selon l'une des revendications 1 à 14, lequel est terminé avec une impédance de 200/200 Ω.

19. Utilisation d'un filtre SAW selon l'une des revendications précédentes dans un mode de fonctionnement asymétrique/symétrique.

20. Utilisation d'un filtre SAW selon l'une des revendications précédentes dans un mode de fonctionnement symétrique/symétrique.

FIG 1

121    IN    122    100

131    160    110    132    190

171    161    OUT bal    162    172

X

FIG 2

OUT bal    OUT bal

281    271    261    262    272    282    290

240    260    241    200

X

231    221    210    IN    222    232

# FIG 3

# FIG 4

## FIG 5

OUT bal          OUT bal

590

IN bal

511

500

510     IN bal

IN bal

## FIG 6

OUT bal          OUT bal

661          662

690

610     660

600

611     612

X

IN

## FIG 7

## FIG 9

## FIG 8

OUT⁻

M

OUT⁺

G

IN

## FIG 12

OUT⁻

M

OUT⁺

G

IN⁻

IN⁺

## FIG 13

IN bal
(IN unbal)

1300

1331  1321      1310    IN bal
(IN ground)    1322  1332

OUT bal

1390

X

1381  1371      1360    OUT bal    1372  1382

M

# FIG 10

# FIG 11

## FIG 14

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0836278 A

**In der Beschreibung aufgeführte Nicht-Patentliteratur**

- **VON G. ENDOH ; M.UEDA ; O. KAWACHI ; Y. FU-JIWARA.** High Performance Balanced Type SAW Filters. *IEEE, Ultrasonics Symposium,* Oktober 1997